# EUROPEAN PATENT SPECIFICATION

(11) **EP 1 119 155 B1**
(45) Date of publication and mention of the grant of the patent: **23.03.2005**
(21) Application number: 00610006.9
(22) Date of filing: 20.01.2000
(51) Int. Cl.: H04M 1/02, B44F 7/00, B44C 5/00

(54) **Electronic equipment provided with a shell element having a three dimensional appearance**
Schalenteil eines elektronischen Geräts mit einer dreidimensionalen Erscheinung
Equipement électronique muni d'un élément de boitier ayant une apparence tridimensionnelle

(43) Date of publication of application: 25.07.2001
(73) Proprietor: Telefonaktiebolaget LM Ericsson (publ), 164 83 Stockholm (SE)
(72) Inventor: Palmqvist, Fredrik, 245 92 Staffanstorp (SE); Andersson, Magnus, SE-245 62 Hjärup (SE)
(74) Representative: Boesen, Johnny Peder

(56) References cited:
- WO-A-98/56221
- US-A- 4 303 716
- US-A- 4 863 782
- US-A- 5 296 340
- PATENT ABSTRACTS OF JAPAN vol. 017, no. 430 (M-1460), 10 August 1993 (1993-08-10) & JP 05 092538 A (TOPPAN PRINTING CO LTD), 16 April 1993 (1993-04-16)

## Description

The invention relates to electronic equipment provided with a shell element which is a part of an outer casing of the electronic equipment.

The appearance of a product is very important for the product to appeal to customers. Even with electronic equipment, such as mobile telephones, computers, televisions, etc., the appearance of the product is often as important as the technology inside the product. Therefore, there is a desire to give different kinds of products different outer appearances in order to appeal to different kinds of customers.

One way of bringing about an attractive outer appearance is to provide the product in question with an outer panel having a three-dimensional look. This is known in for instance car dashboards and sports equipment in which a thermoset plastics material reinforced with a fibre weave is used. The fibre weave is visible at the surface of the appliance and gives the surface a three-dimensional look.

The use of thermoset plastics material is, however, undesired since the process of manufacturing a panel using a thermoset plastics material is an environmentally harmful process and since the finished panel is difficult to recycle. Furthermore, the panel is expensive due to the labour intensive process in making the panel resulting in long cycle times and is therefore not suitable for high volume production of small parts. Finally, the thermoset plastics material does not give chemical bonding to thermoplastics materials, meaning that it is neither possible to weld the thermoset plastics material to a thermoplastics material nor to use the thermoset plastics material as a basis for over-moulding with a thermoplastics material.

Other means of giving a surface a weave look is to use printed foils, tampo-prints or other similar two-dimensional techniques on the surface. This, however, does not give a true three-dimensional look.

It is known from WO 90/03880, US Patent Nos. 4,891,399 and 4,925,615 and Finnish Patent No. 96,750 to manufacture fibre reinforced plastics products of a thermoplastics material with reinforcing fibres. The products are manufactured by heating a sheet and forming the heated sheet in a mould to the desired form. The fibres in these known products are chopped up into short strands and are added only for increasing the strength and rigidity of the products. WO- 98/56221 discloses an outer cesing of an electronic device wherein the decorative visual effect is a changing of colour.

The object of the present invention is to provide electronic equipment provided with a shell element as a part of the outer casing of the electronic equipment, said shell being a structural part of the casing and having a true three-dimensional look. The shell should be made in an environmentally unharmful method and should be suitable for high volume production of small parts.

This is achieved by using a shell element which comprises a fibre weave reinforced thermoplastics laminate comprising a fibre weave with continuous fibres impregnated with a transparent thermoplastics material so that the shell element has a true three-dimensional appearance.

Hereby the shell element can be made as a structural part of the casing of the electronic equipment and, since the thermoplastics material used is transparent, the three-dimensional structure of the fibre weave is visible from the outside. The use of a thermoplastics material makes the manufacturing of the shell element environmentally unharmful compared to the use of a thermosetting plastics material. Furthermore, the cycle time of producing a shell element from a thermoplastics material is short, and this material is therefore highly suitable for high volume production of small parts. Finally, the thermoplastics material gives chemical bonding to thermoplastics materials, meaning that the shell element can be bonded to other thermoplastics parts of the electronic equipment e.g. by welding, gluing or over-moulding.

In a preferred embodiment the shell element comprises a single layer of a fibre weave. In this case, the shell element typically has a thin wallthickness essentially corresponding to the thickness of the fibre weave, but optionally it may comprise a thicker layer of the transparent thermoplastics material, thereby changing the visual appearance of the shell element. In use, the shell element will normally be bonded to another part of the electronic equipment, e.g. by welding, gluing or over-moulding.

The fibres in the fibre weave may comprise a number of fibre types, e.g. carbon fibres, aramide fibres, glass fibres, etc., in any combination in order to meet specific strength or rigidity requirements and/or to enhance the appearance of the shell. The fibres in the fibre weave can also have different colours.

In a preferred embodiment the thermoplastics material is polyamide, preferably polyamide(12), which has excellent material properties in relation to manufacture and chemical bonding to other thermoplastics materials.

As mentioned, the shell element can be glued to a part of the casing of the electronic equipment using e.g. two-component epoxy glue.

In another embodiment of the invention, the shell element is chemically bonded to a part of the casing of the electronic equipment by over-moulding, i.e. the finished shell element is positioned in a mould for injection moulding and the part of the casing is moulded directly on the back of the shell element.

In a special embodiment the fibre weave is provided with electrically conducting fibres that can be used for connecting electronic components, e.g. an amplifier could be electrically connected to a loudspeaker via a wire in the fibre weave.

Since the material used for manufacturing the shell element is relatively expensive, the invention finds particular use in connection with small electronic equipment, such as mobile telephones. The shell element can be a structural part of the casing as well as a decorative part of the mobile telephone.

The invention will be described in detail in the following with reference to the drawings, in which
Fig. 1 shows a mobile telephone provided with a shell element according to the invention, and
Fig. 2 shows a process for manufacturing a shell element for use as a structural and decorative element in a mobile telephone.

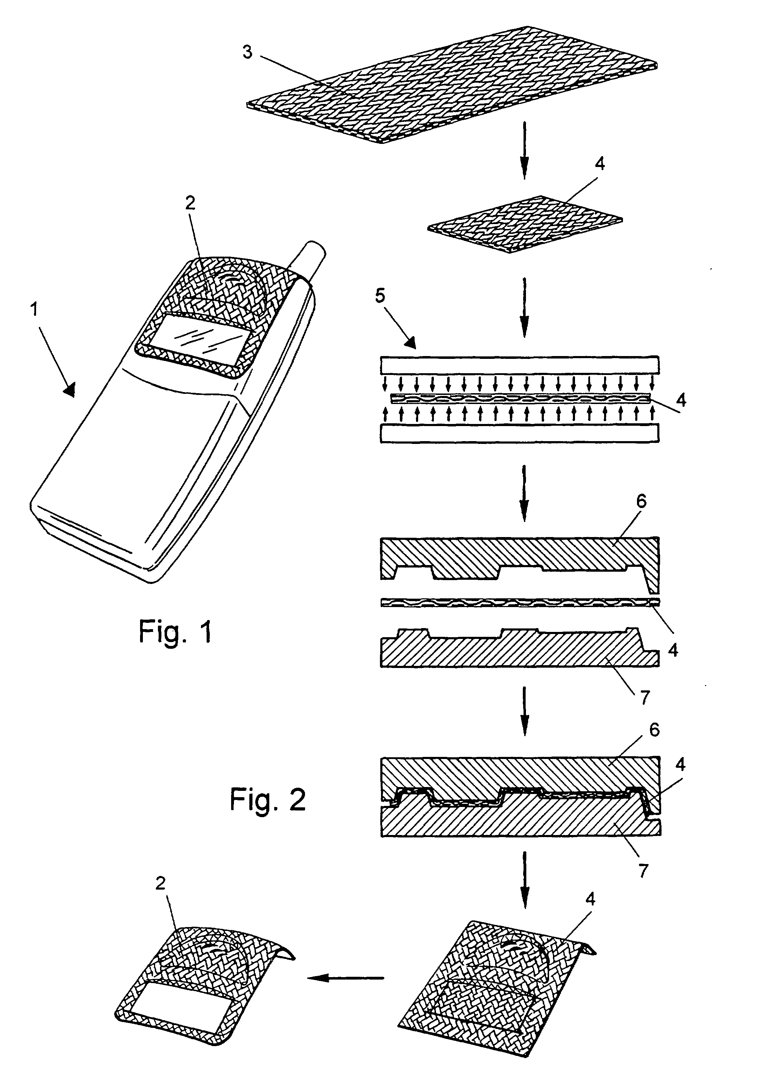

Fig. 1 shows a mobile telephone 1 provided with a shell element 2 according to the invention. The shell element 2 is positioned as a part of the front of the mobile telephone 1, while the rest of the mobile telephone 1 has a casing made in a conventional way.

The shell element 2 is a structural part of the casing of the mobile telephone 1 and can be a separate part connected to other parts to form the casing. Preferably, however, the shell element 2 is mounted as an outer shell on the casing of the mobile telephone 1. In the simplest way, the shell element 2 is glued to the underlying part of the casing, using for instance a two-component epoxy glue that is bondable to the resin of the shell element 2 and to the underlying casing that, conventionally, would also be a thermoplastics material, such as PC or ABS.

Another way of mounting the shell element 2 on the underlying casing is to place the shell element 2 in a suitable mould and over-mould the casing or a part of the casing directly on top of the back of the shell element 2. This, of course, requires that the casing is made of a material that is chemically bondable to the resin of the shell element 2.

The shell element 2 may be provided with other functional features than the structural ones. For instance, a metal wire may be provided in the fibre weave, said metal wire being used as an electrical current conducting element connectable to electronic components. A metal wire could also be incorporated, having the function of an antenna for the mobile telephone 1. Connecting the metal wire in the fibre weave with electronic components could be accomplished by means of metal spikes or the like that are able to penetrate the resin of the fibre weave laminate. These possible features are not shown in detail.

If the fibre weave is made of an electrically conducting material, the shell element could be used as a shield for electronic equipment against electromagnetic radiation.

Fig. 2 shows a process for manufacturing the shell element 2 for use in the mobile telephone 1 as shown in Fig. 1.

A large sheet 3 comprises a fibre weave thermoplastics laminate having one layer of fibre weave. The resin used is preferably polyamide(12) but could also be chosen from other thermoplastics materials, such as polyamide(6), polycarbonate, etc.

Since one of the objects of the invention is to provide electronic equipment with a shell element that exhibits a true three-dimensional outer appearance many kinds of fibres are applicable, though they must have a melting point higher than the melting point of the resin used. Examples of fibres are carbon fibres, aramide fibres, glass fibres, metalized fibres, metal fibres, thermoplastics fibres, etc.

Additionally, the fibre weave may have any desired texture. For instance, it can be a simple weaving where bundles of fibres are interwoven in a regular pattern, as shown in Figs. 1 and 2, or it can be a complex weaving including markings, such as trade marks, letters, etc., in the pattern.

Apart from the texture of the fibre weave, the colour and composition of the fibre weave can be varied. For instance, aramide fibres of different colours could be used, thereby creating an interesting pattern in the fibre weave. Similarly, the fibres could be a mix of different kind of fibres, e.g. carbon fibres and metal fibres, thereby creating interesting patterns. The composition of the fibre weave may also be adapted to any special purposes, such as current conducting, specific strength or rigidity requirements in any direction, etc.

In order to increase the rigidity and strength and/or the thickness of the shell element, more than one fibre weave layer could be applied. It is also possible to vary the thickness of the shell element by using different numbers of fibre weave layers at different areas of the shell element.

If the outermost visible fibre weave layer primarily has the fibres oriented in a certain direction, another fibre layer having the fibres oriented in a direction perpendicular to the fibre direction of the outermost layer may advantageously be provided. This second fibre weave layer balances the composite laminate, preventing wryness of the finished shell element.

When manufacturing the shell element, the sheet 3 comprising e.g. a polyamide(12) resin and 40% by volume carbon fibres is cut into smaller workpieces 4 corresponding to the size of one or more shell elements. The workpiece 4 is heated, e.g. in an infra-red oven 5, to a temperature above the melting point of the thermoplastics material. If, for instance, the thermoplastics material used is polyamide, the workpiece 4 is heated to approximately 20°C above the melting point of the polyamide.

The heated workpiece 4 is then transferred to a mould having an upper mould part 6 and a complementary lower mould part 7. The heated workpiece 4 is positioned between the mould parts 6, 7 which are pressed together, thereby deforming the workpiece 4 to a desired shape. After cooling, setting the thermoplastics material, the workpiece 4 is removed from the mould and transferred to a cutting station (not shown) where the edges are cut and optionally holes are drilled or punched.

The cutting station can be of any conventional type, including metal cutters, drills, laser cutting apparatuses, water cutting apparatuses, etc.

The workpiece - now a finished shell element 2 - is then ready to be mounted as a surface part of the mobile telephone 1 or any other electronic equipment by gluing, welding, over-moulding or any other means.

Since the workpiece 4 is heated to a temperature above the melting point of the resin, the deformed workpiece 4 is substantially free of any internal stress. Therefore, the deformed workpiece 4 substantially maintains its shape even after the edges have been cut and any holes drilled or punched in order to form the finished shell element.

It should be emphasized that the term "comprises/comprising" when used in this specification is taken to specify the presence of stated features, integers, steps or components, but does not preclude the presence or addition of one or more other features, integers, steps components or groups thereof.

## Claims

1. Electronic equipment provided with a shell element (2), said shell element (2) being a structural part of an outer casing of the electronic equipment, **characterised in that** the shell element (2) comprises a fibre weave reinforced thermoplastics laminate comprising a fibre weave with continuous fibres impregnated with a transparent thermoplastics material so that the shell element (2) has a true three-dimensional appearance.

2. Electronic equipment according to claim 1, **characterised in that** the shell element (2) comprises a single layer of a fibre weave.

3. Electronic equipment according to claims 1 or 2, **characterised in that** the fibres in the fibre weave comprise carbon fibres.

4. Electronic equipment according to any one of claims 1-3, **characterised in that** the fibres in the fibre weave comprise aramide fibres.

5. Electronic equipment according to any one of claims 1-4, **characterised in that** the fibres in the fibre weave comprise glass fibres.

6. Electronic equipment according to any one of claims 1-5, **characterised in that** the fibres in the fibre weave have different colours.

7. Electronic equipment according to any one of claims 1-6, **characterised in that** the thermoplastics material is polyamide, preferably polyamide(12).

8. Electronic equipment according to any one of claims 1-7, **characterised in that** the shell element (2) is glued to a part of the casing of the electronic equipment.

9. Electronic equipment according to any one of claims 1-7, **characterised in that** the shell element (2) is chemically bonded to a part of the casing of the electronic equipment by over-moulding.

10. Electronic equipment according to any one of claims 1-9, **characterised in that** electronic components are connected to electrically conducting fibres provided in the fibre weave of the shell element (2).

11. Electronic equipment according to any one of claims 1-10, **characterised in that** the electronic equipment is a mobile radio station, such as a mobile telephone (1).

## Patentansprüche

1. Mit einem Schalenteil (2) versehenes elektronisches Gerät, bei dem das Schalenteil (2) ein struktureller Teil eines äußeren Gehäuses des elektronischen Geräts ist, **dadurch gekennzeichnet, dass** das Schalenteil (2) mit Fasergewebe verstärkte thermoplastische Laminate, umfassend ein Fasergewebe mit kontinuierlichen Fasern, die mit einem transparenten thermoplastischen Material imprägniert sind, umfasst, so dass das Schalenteil (2) einen echte 3-dimensionale Erscheinung aufweist.

2. Elektronisches Gerät gemäß Anspruch 1, **dadurch gekennzeichnet, dass** das Schalenteil (2) eine einzelne Schicht aus einem Fasergewebe aufweist.

3. Elektronisches Gerät gemäß Ansprüchen 1 oder 2, **dadurch gekennzeichnet, dass** die Fasern in dem Fasergewebe Karbonfasern umfassen.

4. Elektronisches Gerät gemäß einem der Ansprüche 1 bis 3, **dadurch gekennzeichnet, dass** die Fasern in dem Fasergewebe Aramidfasern umfassen.

5. Elektronisches Gerät gemäß einem der Ansprüche 1 bis 4, **dadurch gekennzeichnet, dass** die Fasern in dem Fasergewebe Glasfasern umfassen.

6. Elektronisches Gerät gemäß einem der Ansprüche 1 bis 5, **dadurch gekennzeichnet, dass** die Fasern in dem Fasergewebe verschiedene Farben aufweisen.

7. Elektronisches Gerät gemäß einem der Ansprüche 1 bis 6, **dadurch gekennzeichnet, dass** das thermoplastische Material Polyamid, vorzugsweise Polyamid (12) ist.

8. Elektronisches Gerät gemäß einem der Ansprüche 1 bis 7, **dadurch gekennzeichnet, dass** das Schalenteil (2) an einem Teil des Gehäuses des elektronischen Geräts angeklebt ist.

9. Elektronisches Gerät gemäß einem der Ansprüche 1 bis 7, **dadurch gekennzeichnet, dass** das Schalenteil (2) chemisch mit einem Teil des Gehäuses des elektronischen Geräts durch Übergießen verbunden ist.

10. Elektronisches Gerät gemäß einem der Ansprüche 1 bis 9, **dadurch gekennzeichnet, dass** die elektronischen Komponenten mit elektrisch leitfähigen Fasern, die in dem Fasergewebe des Schalenteils (2) vorgesehen sind, verbunden sind.

11. Elektronisches Gerät gemäß einem der Ansprüche 1 bis 10, **dadurch gekennzeichnet, dass** das elektronische Gerät eine mobile Funksendestelle, so wie ein Mobiltelefon (1) ist.

## Revendications

1. Equipement électronique pourvu d'un élément de coque (2), ledit élément de coque (2) étant une partie de structure d'un boîtier extérieur de l'équipement électronique, **caractérisé en ce que** l'élément de coque (2) comporte un stratifié thermoplastique renforcé par une armure de fibres comprenant une armure de fibres avec des fibres continues imprégnées d'une matière thermoplastique transparente afin que l'élément de coque (2) présente un aspect tridimensionnel vrai.

2. Equipement électronique selon la revendication 1, **caractérisé en ce que** l'élément de coque (2) comprend une couche unique d'une armure de fibres.

3. Equipement électronique selon les revendications 1 ou 2, **caractérisé en ce que** les fibres de l'armure de fibres comprennent des fibres de carbone.

4. Equipement électronique selon l'une quelconque des revendications 1 à 3, **caractérisé en ce que** les fibres dans l'armure de fibres comprennent des fibres d'aramide.

5. Equipement électronique selon l'une quelconque des revendications 1 à 4, **caractérisé en ce que** les fibres dans l'armure de fibres comprennent des fibres de verre.

6. Equipement électronique selon l'une quelconque des revendications 1 à 5, **caractérisé en ce que** les fibres dans l'armure de fibres ont des couleurs différentes.

7. Equipement électronique selon l'une quelconque des revendications 1 à 6, **caractérisé en ce que** la matière thermoplastique est un polyamide, avantageusement un polyamide (12).

8. Equipement électronique selon l'une quelconque des revendications 1 à 7, **caractérisé en ce que** l'élément de coque (2) est collé à une partie du boîtier de l'équipement électronique.

9. Equipement électronique selon l'une quelconque des revendications 1 à 7, **caractérisé en ce que** l'élément de coque (2) est lié chimiquement par surmoulage à une partie du boîtier de l'équipement électronique.

10. Equipement électronique selon l'une quelconque des revendications 1 à 9, **caractérisé en ce que** des composants électroniques sont connectés à des fibres électriquement conductrices situées dans l'armure de fibres de l'élément de coque (2).

11. Equipement électronique selon l'une quelconque des revendications 1 à 10, **caractérisé en ce que** l'équipement électronique est une station radio mobile, telle qu'un téléphone mobile (1).
